(19) Europäisches Patentamt
European Patent Office
Office européen des brevets

(11) EP 4 748 966 A1

(12) # EUROPEAN PATENT APPLICATION
published in accordance with Art. 153(4) EPC

(43) Date of publication:
**27.05.2026 Bulletin 2026/22**

(21) Application number: **24856544.2**

(22) Date of filing: **23.08.2024**

(51) International Patent Classification (IPC):
***C23C 16/18*** (2006.01) ***C07F 15/06*** (2006.01)
***C23C 16/16*** (2006.01) ***H10D 64/60*** (2025.01)

(52) Cooperative Patent Classification (CPC):
**C07F 15/06; C23C 16/16; C23C 16/18; H10D 64/60**

(86) International application number:
**PCT/JP2024/030046**

(87) International publication number:
**WO 2025/041856 (27.02.2025 Gazette 2025/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.08.2023 JP 2023136534**

(71) Applicants:
- **Daikin Industries, Ltd.**
  **Osaka-shi, Osaka 530-0001 (JP)**
- **The University of Tokyo**
  **Bunkyo-ku, Tokyo 113-8654 (JP)**

(72) Inventors:
- **YAMAUCHI, Akiyoshi**
  **Osaka-Shi, Osaka 530-0001 (JP)**
- **KISHIKAWA, Yosuke**
  **Osaka-Shi, Osaka 530-0001 (JP)**
- **SAGISAKA, Shigehito**
  **Osaka-Shi, Osaka 530-0001 (JP)**
- **HAYASHI, Hisataka**
  **Osaka-Shi, Osaka 530-0001 (JP)**
- **NAKAMURA, Shingo**
  **Osaka-Shi, Osaka 530-0001 (JP)**
- **HORIGUCHI, Kazunori**
  **Osaka-Shi, Osaka 530-0001 (JP)**
- **HOSHIYA, Naoyuki**
  **Osaka-Shi, Osaka 530-0001 (JP)**
- **SHIMOGAKI, Yukihiro**
  **Tokyo 113-8654 (JP)**
- **YAMAGUCHI, Jun**
  **Tokyo 113-8654 (JP)**
- **MOMOSE, Takeshi**
  **Tokyo 113-8654 (JP)**
- **SATO, Noboru**
  **Tokyo 113-8654 (JP)**

(74) Representative: **Hoffmann Eitle**
**Patent- und Rechtsanwälte PartmbB**
**Arabellastraße 30**
**81925 München (DE)**

(54) **METAL COMPLEX**

(57) The present invention provides a raw material complex for forming a thin metal film, having a central metal and a ligand coordinated to the central metal, wherein the central metal has an atomic polarizability of 45 to 51 and the complex satisfies the following conditions: a polarizability volume ≤ 200 and a relative dielectric constant ≤ 2.20.

EP 4 748 966 A1

## Description

Technical Field

The present disclosure relates to a metal complex.

Background Art

Methods using an atomic layer deposition (hereinafter also referred to as ALD) have been known as methods of film deposition on various substrates, and various metal compounds are used as raw material compounds.

Citation List

Patent Literature

Patent Literature 1
JP 2021-36068 A

Summary of Invention

Technical Problem

An object of the present disclosure is to provide a complex capable of forming a film with a low impurity content when used to form a metal film.

Solution to Problem

The present disclosure includes the following embodiments.

[Item 1]

A raw material complex for forming a thin metal film, having a central metal and a ligand coordinated to the central metal,
wherein the central metal has an atomic polarizability of 45 to 51 and the complex satisfies the following conditions:

$$\text{a polarizability volume} \leq 200$$

and

$$\text{a relative dielectric constant} \leq 2.20.$$

[Item 2]

A raw material complex for forming a thin metal film, having a central metal and a ligand coordinated to the central metal,
wherein the central metal has an atomic polarizability of 52 to 90 and the complex satisfies the following conditions:

$$\text{a polarizability volume} \leq 240$$

and

$$\text{a relative dielectric constant} \leq 2.50.$$

[Item 3]

The raw material complex for forming a thin metal film according to item 1 or 2, satisfying that an area having a

surface charge density of 0.007 e/Å$^2$ or more is 10% or less with respect to an entire complex molecular area, or an area having a surface charge density of -0.007 e/Å$^2$ or less is 10% or less with respect to an entire complex molecular area.

[Item 4]

The raw material complex for forming a thin metal film according to any one of items 1 to 3, wherein the ligand is a monodentate ligand, a polydentate ligand, or both thereof.

[Item 5]

The raw material complex for forming a thin metal film according to any one of items 1 to 4, wherein an atom that coordinates with a metal in the ligand has a Pauling electronegativity of 3.1 or less.

[Item 6]

The raw material complex for forming a thin metal film according to any one of items 1 to 5, wherein the ligand has at least one branched alkyl group having three or more carbon atoms.

[Item 7]

The raw material complex for forming a thin metal film according to any one of items 4 to 6, wherein the monodentate ligand is carbonyl, alkyne, alkyl, fluoroalkyl, allyl, aminoalkyl, hydride, or alkylsilane.

[Item 8]

The raw material complex for forming a thin metal film according to any one of items 4 to 6, wherein the polydentate ligand is a bidentate ligand, and the bidentate ligand is alkyldiene, cyclopentadiene, acetylacetonate, alkyldiamine, or alkyldisilane.

[Item 9]

The raw material complex for forming a thin metal film according to any one of items 4 to 6, wherein the polydentate ligand is a tridentate ligand, and the tridentate ligand is amidinate.

[Item 10]

The raw material complex for forming a thin metal film according to any one of items 1 to 9, wherein the central metal has an oxidation number of 1 or greater.

[Item 11]

The raw material complex for forming a thin metal film according to any one of items 1 and 3 to 10, wherein the central metal is cobalt, nickel, or copper.

[Item 12]

The complex for forming a thin metal film according to any one of items 1 and 3 to 11, having a vapor pressure at 100°C of 6.0 Torr or more.

[Item 13]

The complex for forming a thin metal film according to any one of items 1 and 3 to 12, wherein the central metal is cobalt and the complex has a vapor pressure at 100°C of 6.0 Torr or more.

[Item 14]

The complex for forming a thin metal film according to any one of items 1 and 3 to 13, wherein the central metal is nickel and the complex has a vapor pressure at 100°C of 6.3 Torr or more.

[Item 15]

The complex for forming a thin metal film according to any one of items 1 and 3 to 14, wherein the central metal is copper and the complex has a vapor pressure at 100°C of 6.7 Torr or more.

[Item 16]

The raw material complex for forming a thin metal film according to any one of item 2 to 10, wherein the central metal is molybdenum, ruthenium, or tungsten.

[Item 17]

The complex for forming a thin metal film according to any one of items 2 to 10 and 16, having a vapor pressure at 100°C of 0.6 Torr or more.

[Item 18]

The complex for forming a thin metal film according to any one of items 2 to 10, 16 and 17, wherein the central metal is molybdenum and the complex has a vapor pressure at 100°C of 0.6 Torr or more.

[Item 19]

The complex for forming a thin metal film according to any one of items 2 to 10 and 16 to 18, wherein the central metal is ruthenium and the complex has a vapor pressure at 100°C of 2.8 Torr or more.

[Item 20]

The complex for forming a thin metal film according to any one of items 2 to 10 and 16 to 19, wherein the central metal is tungsten and the complex has a vapor pressure at 100°C of 3.6 Torr or more.

[Item 21]

The complex for forming a thin metal film according to any one of items 1 to 20, for use in an atomic layer deposition.

[Item 22]

An atomic layer deposition, using the complex according to any one of items 1 to 21 as a raw material compound.

[Item 23]

The atomic layer deposition according to item 22, wherein a film deposition temperature upon film deposition using the complex according to any one of items 1 to 21 is 200°C or lower.

[Item 24]

The atomic layer deposition according to item 22 or 23 for use in production of semiconductor substrates.

[Item 25]

A method for selecting a raw material complex for use in an atomic layer deposition, comprising selecting the raw material complex which has

a central metal having an atomic polarizability of 45 to 51,
a polarizability volume of 200 or less,
a relative dielectric constant of 2.20 or less, and
a surface charge density such that an area having a surface charge density of 0.007 e/Å$^2$ or more is 10% or less with respect to an entire molecular area, or an area having a surface charge density of -0.007 e/Å$^2$ or less is 10% or less with

respect to an entire molecular area.

[Item 26]

A method for selecting a raw material complex for use in an atomic layer deposition, comprising selecting the raw material complex which has

a central metal having an atomic polarizability of 52 to 90,
a polarizability volume of 220 or less,
a relative dielectric constant of 2.50 or less, and
a surface charge density such that an area having a surface charge density of 0.007 e/$Å^2$ or more is 10% or less with respect to an entire molecular area, or an area having a surface charge density of -0.007 e/$Å^2$ or less is 10% or less with respect to an entire molecular area.

[Item 27]

The method according to item 25, wherein the complex has a vapor pressure at 100°C of 1.0 Torr or more.

[Item 28]

The method according to item 25 or 27, wherein the central metal of the complex is cobalt, nickel, or copper.

[Item 29]

The method according to claim 26, wherein the complex has a vapor pressure at 100°C of 0.6 Torr or more.

[Item 30]

The method according to item 26 or 29, wherein the central metal of the complex is molybdenum, ruthenium, or tungsten.

[Item 31]

The method according to any one of items 25 to 30, wherein the polarizability volume, the relative dielectric constant, the surface charge density, and the vapor pressure of the complex are determined by simulation.

[Item 32]

The method according to item 31, wherein the simulation is at least one of a COSMO-SAC method, a DFT method, and an AMS method.

[Item 33]

The method according to item 32, wherein the COSMO-SAC method used in the simulation is a modified COSMO-SAC method.

Advantageous Effects of Invention

The complex disclosed herein has a high vapor pressure, allowing for low-temperature vaporization when used as a raw material compound for ALD, as a result of which the complex disclosed herein is inhibited from its decomposition by heat.

Brief Description of Drawings

[Figure 1] Figure 1 is a schematic view illustrating an example of a film deposition apparatus for carrying out the atomic layer deposition disclosed herein.

[Figure 2] Figure 2 is a graph plotted with the values calculated using the calculation method of the present invention (by Rev. 3) and the values calculated using the existing COSMO-SAC method.
[Figure 3] Figure 3 is a table showing the values calculated using the calculation method of the present invention (by Rev. 3) and the values calculated using the existing COSMO-SAC method.
[Figure 4] Figure 4 is the results of TG-DTA analysis for the compound of Example 1.
[Figure 5] Figure 5 is a graph illustrating the comparison between the calculated values and measured values of the vapor pressures of the compound of Example 1.
[Figure6] Figure 6 is the results of TG-DTA analysis for the compound of Comparative Example 1.

Description of Embodiments

The present disclosure will be described below. With the proviso that the following description is intended to concretize the technical ideas according to the present disclosure, and the invention is not limited to the following, unless otherwise specified.

(Complex)

The complex disclosed herein has a central metal and a ligand coordinated to the central metal, wherein (i) the central metal has an atomic polarizability of 45 to 51, and the complex satisfies the following conditions:

$$\text{a polarizability volume} \leq 200$$

and

$$\text{a relative dielectric constant} \leq 2.20 \text{ or}$$

the complex has a central metal and a ligand coordinated to the central metal, or wherein
(ii) the central metal has an atomic polarizability of 52 to 90, and the complex satisfies the following conditions:

$$\text{a polarizability volume} \leq 240$$

and

$$\text{a relative dielectric constant} \leq 2.50.$$

In ALD, a raw material compound is typically vaporized in a vaporizer, and the gaseous raw material compound is then introduced into a film deposition chamber, and is deposited on a substrate to form a film of the raw material compound in the film deposition chamber. This film of such a raw material compound is then reduced to form, for example, a metal film. That is, in ALD, a raw material compound is first vaporized, and generally heated during the vaporization. However, an elevated heating temperature can cause decomposition of the complex, resulting in a risk of a decomposition product being contaminated into a film as an impurity.
The complex disclosed herein that satisfies the above conditions has, on the other hand, a high vapor pressure. Therefore, the complex disclosed herein can be vaporized at a relatively low temperature. This results in inhibition of the decomposition of the complex and inhibition of an impurity from being contaminated into a film.

(i) In the Case of Central Metal Having Atomic Polarizability of 45 to 51

The complex disclosed herein has a polarizability volume of 200 or less, for example, 190 or less, 180 or less, 170 or less, 160 or less, 150 or less, 140 or less, 130 or less, 125 or less, or 120 or less. The lower limit of the polarizability volume of the complex disclosed herein is not limited, and may be, for example, 10 or more, 30 or more, 50 or more, 60 or more, 70 or more, or 80 or more.
The complex disclosed herein has a relative dielectric constant of 2.20 or less, for example, 2.10 or less, 2.00 or less, 1.90 or less, 1.80 or less, 1.70 or less, or 1.60 or less. The lower limit of the relative dielectric constant of the complex disclosed herein is not limited, and may be, for example, 1.10 or more, 1.20 or more, 1.30 or more, 1.40 or more, or 1.50 or more.
In one embodiment, the complex disclosed herein in case (i) may satisfy the following conditions:

a polarizability volume ≤ 180 and a relative dielectric constant ≤ 2.00;

a polarizability volume ≤ 170 and a relative dielectric constant ≤ 1.90;

a polarizability volume ≤ 160 and a relative dielectric constant ≤ 1.80;

a polarizability volume ≤ 125 and a relative dielectric constant ≤ 2.20;

a polarizability volume ≤ 120 and a relative dielectric constant ≤ 2.20; or

a polarizability volume ≤ 120 and a relative dielectric constant ≤ 2.00.

(ii) In the Case of Central Metal Having Atomic Polarizability of 52 to 90

The complex disclosed herein has a polarizability volume of 240 or less, for example, 234 or less, 230 or less, 220 or less, 210 or less, 200 or less, 190 or less, or 180 or less. The lower limit of the polarizability volume of the complex disclosed herein is not limited, and may be, for example, 10 or more, 30 or more, 50 or more, 60 or more, 70 or more, or 80 or more.

The complex disclosed herein has a relative dielectric constant of 2.50 or less, for example, 2.40 or less, 2.36 or less, 2.30 or less, 2.00 or less, 1.90 or less, 1.80 or less, 1.70 or less, or 1.60 or less. The lower limit of the relative dielectric constant of the complex disclosed herein is not limited, and may be, for example, 1.10 or more, 1.20 or more, 1.30 or more, 1.40 or more, or 1.50 or more.

In one embodiment, the complex disclosed herein in case (ii) may satisfy the following conditions:

a polarizability volume ≤ 220 and a relative dielectric constant ≤ 2.50;

a polarizability volume ≤ 234 and a relative dielectric constant ≤ 2.36;

a polarizability volume ≤ 200 and a relative dielectric constant ≤ 2.40; or

a polarizability volume ≤ 180 and a relative dielectric constant ≤ 2.30.

The complex disclosed herein having a polarizability volume and a relative dielectric constant within the above ranges has a high vapor pressure and can be vaporized at a relatively low temperature.

In one embodiment, the complex has a surface charge density such that an area having a surface charge density of 0.007 e/$Å^2$ or more is preferably 10% or less, more preferably 5% or less, and still more preferably 3% or less, with respect to the entire molecular area.

In one embodiment, the complex has a surface charge density such that an area having a surface charge density of -0.007 e/$Å^2$ or less is preferably 10% or less, more preferably 5% or less, and still more preferably 3% or less, with respect to the entire molecular area.

In one embodiment, the complex has a surface charge density such that an area having a surface charge density of 0.007 e/$Å^2$ or more is preferably 10% or less, more preferably 5% or less, and still more preferably 3% or less, with respect to the entire molecular area, and an area having a surface charge density of -0.007 e/$Å^2$ or less is preferably 10% or less, more preferably 5% or less, and still more preferably 3% or less, with respect to the entire molecular area.

Herein, the entire molecular area is a surface area expressed as an aggregate of atoms having the atomic radii used in a COSMO-SAC method which will be described below.

The polarizability volume, relative dielectric constant, surface charge density, and vapor pressure described above can be measured by simulation.

Examples of the above-described simulation include a COSMO-SAC (Conductor-like Screening Model-Segment Activity Coefficient) method, a DFT (Density Functional Theory) method, and an AMS (Amsterdam Modeling Suit) method.

The COSMO-SAC method is generally applied to calculate a vapor pressure, whereas it is difficult to accurately predict the vapor pressure of the metal complex involved in the present invention. Therefore, in the present invention, the

following procedure has been added to the COSMO-SAC method to improve the accuracy of predicting the vapor pressure of a metal complex. The simulation method with improved vapor pressure prediction accuracy is hereinafter referred to as an "improved COSMO-SAC method." Details of a method for improving prediction accuracy have been described in "Study on Vapor Pressure Prediction of Metal Complexes by COSMO-SAC Method" (Noboru Sato et al., The Society of Chemical Engineers, Japan, 53rd Autumn Meeting), and the main points of which will be described below.

In calculating a vapor pressure in the present invention, the COSMO-SAC method more specifically uses an empirical parameter ($\varepsilon_{dsp}$) determined for each atomic species upon calculating a molecular activity coefficient $\gamma_{dsp}$ due to dispersion force. With the proviso that there is a correlation between $\varepsilon_{dsp}$ and the polarizability of a metal atom, $\alpha_M$, as represented by the correlation equation:

$$\varepsilon_{dsp} = 1035 \times \alpha_M^{1.34}.$$

Such a correlation equation can be used to predict an unknown $\varepsilon_{dsp}$. The polarizability of a metal atom varies depending on a functional group to which the atom is bonded, so that it is determined for each complex. The polarizability of the ligand is subtracted from the polarizability of the complex molecule to determine the polarizability of the central metal, $\alpha_M$ (see, below).

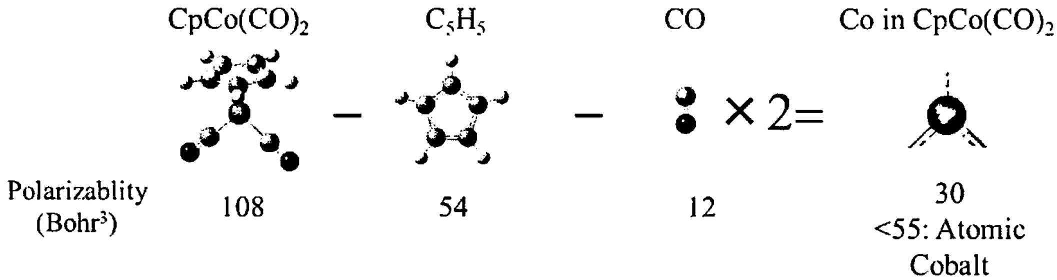


There is a correlation between the polarizability $\alpha_{Mol}$ and $\gamma_{dsp}$ of a molecule, as represented by the following correlation equation:

$$(-T\cdot \ln(\gamma_{dsp}) = \frac{50.0\times\alpha_{Mol}}{1+0.02\alpha_{Mol}})$$

When the value of $-T\cdot\ln(\gamma_{dsp})$ deviates from the correlation equation described above, the calculated vapor pressure $P_{COSMO}$ is overestimated or underestimated by the difference ($\Delta E$) compared to the actual value. This error can be corrected by multiplying $P_{COSMO}$ by $\exp(\Delta E/RT)$, and a more accurate vapor pressure $P_{COSMO}^*$ can be calculated as $P_{COSMO}^* = P_{COSMO} \times \exp(\Delta E/RT)$.

The COSMO-SAC method underestimates vapor pressures of complexes containing tertiary carbon, quaternary carbon, and tertiary nitrogen. The cause is considered to be due to overestimation of the dispersion force of a surface of these branched atoms. Then, a surface area of tertiary atoms is converted to 1/2 thereof and a surface area of quaternary atoms to 0, to calculate a molecular activity coefficient $\gamma_{dsp}^*$, and the calculated vapor pressure $P_{COSMO}^*$ is multiplied by $\gamma_{dsp}^*/\gamma_{dsp}$ to enable an actual vapor pressure to be reproduced.

The results of comparison between the predicted and reported vapor pressures of metal complexes are shown in Figure 2 and Figure 3. As the predicted values, both of values calculated using the "improved COSMO-SAC method" described above and values calculated using the existing COSMO-SAC method are shown. The calculated values of the present invention predict the vapor pressures with higher accuracy than those calculated using the existing method.

The DFT method is applied to prediction of a polarizability volume, a relative dielectric constant, and a surface charge density, and the polarizability volume is predicted using Gaussian09W and measured at the B3LYP/6-311+G(d,p) level. In predicting the relative dielectric constant, AMS (Amsterdam Modeling Suit) is used to predict the density of a metal complex in a liquid-phase, which is necessary for the prediction of the relative dielectric constant, and the polarizability and the density in a liquid phase are used to predict the relative dielectric constant based on the Clausius-Mossotti relational expression. Moreover, the surface charge density is predicted using AMS (Amsterdam Modeling Suit) and measured at the BP86/TZP level.

The complex disclosed herein is preferably an organometallic compound. The organometallic compound is a metal atom and a ligand coordinated to the metal atom, which is specifically, a monodentate ligand and/or a polydentate ligand.

Examples of the monodentate ligand include halogen, hydride, alkyl, alkenyl, cycloalkyl, aryl, alkynyl, alkylimino, amine, dialkylaminoalkyl, monoalkylamino, dialkylamino, alkoxy, alkoxyalkyl, hydrazide, phosphide, nitrile, silyl, and carbonyl.

Examples of a bidentate ligand that is the polydentate ligand include diamine, di(silyl-alkyl)amino, di(alkylsilyl) amino, disilylamino, dialkylaminoalkoxy, alkoxyalkyldialkylamino, siloxy, diketonate, cyclopentadienyl, pyrazolate, ketoiminate and diketiminate.

Examples of a tridentate or higher ligand that is the polydentate ligand include amidinate, guanidinate, phosphaguanidinate, and phosphaamidinate.

The above-described ligand has an atom coordinating to a metal in the ligand, which the atom has a Pauling electronegativity of 3.1 or less, and the ligand may be a monodentate, bidentate, or tridentate ligand.

In some embodiments, the ligand is preferably carbonyl, alkyne, alkylamine, or hydride, as a monodentate ligand.

In some embodiments, the ligand is preferably alkyldiene, cyclopentadiene, or acetylacetonate, as a bidentate ligand.

In some embodiments, the ligand is preferably amidinate, as a tridentate ligand.

(i) In the Case of Central Metal Having Atomic Polarizability of 45 to 51

The central metal of the complex disclosed herein may preferably be cobalt, nickel, or copper and more preferably cobalt.

(ii) In the Case of Central Metal Having Atomic Polarizability of 52 to 90

The central metal of the complex disclosed herein may preferably be molybdenum, ruthenium, or tungsten and more preferably ruthenium or tungsten.

Having the above-described central metal may allow the complex of the present disclosure to have a higher vapor pressure.

(i) In the Case of Central Metal Having Atomic Polarizability of 45 to 51

The vapor pressure of the complex disclosed herein at 100°C may preferably be 1.0 Torr or higher, more preferably 2.0 Torr or higher, and still more preferably 3.0 Torr or higher, and it may be, for example, 3.5 Torr or higher, 4.5 Torr or higher, 5.5 Torr or higher, 6.0 Torr or higher, 6.3 Torr or higher, or 6.7 Torr or higher. The upper limit of the vapor pressure of the complex disclosed herein at 100°C is not limited, and may be, for example, 55 Torr or less, 50 Torr or less, 45 Torr or less, 40 Torr or less, 35 Torr or less, 30 Torr or less, 25 Torr or less, 20 Torr or less, 15 Torr or less, 10 Torr or less, 8 Torr or less, 7 Torr or less, or 6 Torr or less.

In a preferred embodiment,

the central metal is cobalt and the complex has a vapor pressure at 100°C of 6.0 Torr or more;
the central metal is nickel and the complex has a vapor pressure at 100°C of 6.3 Torr or more; or
the central metal is copper and the complex has a vapor pressure at 100°C of 6.7 Torr or more.

(ii) In the Case of Central Metal Having Atomic Polarizability of 52 to 90

The vapor pressure of the complex disclosed herein at 100°C is preferably 0.6 Torr or more, more preferably 1.0 Torr or more, still more preferably 2.0 Torr or more, and even still more preferably 2.8 Torr or more, and it may be for example 3.0 Torr or more, 3.5 Torr or more, 3.6 Torr or more, 4.5 Torr or more, or 5.5 Torr or more. The upper limit of the vapor pressure of the complex disclosed herein at 100°C is not limited, and may be, for example, 10 Torr or less, 8 Torr or less, 7 Torr or less, or 6 Torr or less.

In a preferred embodiment,

the central metal is molybdenum, and the complex has a vapor pressure at 100°C of 0.6 Torr or more;
the central metal is ruthenium, and the complex has a vapor pressure at 100°C of 2.8 Torr or more; or
the central metal is tungsten, and the complex has a vapor pressure at 100°C of 3.6 Torr or more.

The vapor pressures staying within the above ranges allow for vaporization of the complex at low temperatures and inhibit decomposition of the complex. This ultimately inhibits an impurity from being contaminated into a film in ALD using the complex disclosed herein as a raw material.

The vapor pressure of the complex disclosed herein can be measured by introducing the complex into a bottle

equipped with a pressure system and measuring it at each specified temperature.

When the ligand of the complex disclosed herein contains an alkyl group having three or more carbon atoms, the alkyl group may preferably have branched carbon. In other words, the complex disclosed herein may have at least one branched alkyl group having three or more carbon atoms.

Examples of the complex disclosed herein include the following complexes:

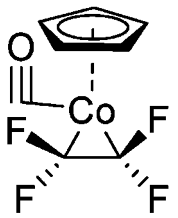
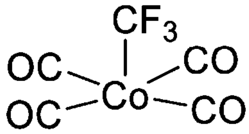
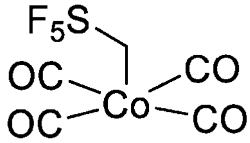

The complex disclosed herein can be used in a variety of applications, including, for example, an atomic layer deposition, a chemical vapor deposition, catalytic applications (for example, a catalyst for hydrogen fuel cells and a catalyst for hydrogen generation reactions), a cathode electrode for lithium ion batteries, a battery anode, a photodetector, a biosensing, a high-performance thermoelectric material, and a catalyst.

Currently, in semiconductor manufacturing processes, many chemical vapor deposition growth methods (CVD) and atomic layer deposition (ALD) processes using metal complexes have been utilized.

The film types thereof are widely ranged, including, in addition to metal films, a metal nitride, a metal oxide, and a metal carbide, which have been widely investigated in the following processes:

- High relative dielectric constant gate insulating films: HfOx, HfLaOx, and the like.
- Gate cap films: TiAlOx and the like.
- Capacitor insulating films (for DRAM): ZrOx, AlOx, HfOx, and the like.
- Block oxide films (for flash memories): AlOx and the like.
- Metal gate electrodes (including a work function metal): W, TiN, TaN, TiAlC, TiAlN, and the like.
- Wiring materials (including a barrier metal, a liner metal, a seed metal, and a metal cap): Cu, Co, Ru, Mo, TaN, TiN, MoN, WC, and the like.
- Buried materials for via holes and contact holes (including an adhesion layer): W, Mo, Co, Ru, TiN, MoN, WC, and the like.
- Metal hard masks (including a sidewall spacer): TiN, TiOx, and the like.
- Etching stop layers: AlO, AlNO, and the like.
- Materials for promoting selective growth of metal films (wiring materials and buried materials): Pd and the like.
- Highly thermal conductive insulating films: AlN and the like.

Furthermore, even in an atomic layer etching (ALE) process, a metal complex may be used to etch a difficult-to-etch material such as a high relative dielectric constant insulating film.

(Atomic Layer Deposition)

The present disclosure provides an atomic layer deposition using the above-described complexes of the present disclosure as raw material compounds.

The complex disclosed herein has a high vapor pressure and therefore can be vaporized at a relatively low temperature, for example, 200°C or lower. Accordingly, vaporization at low temperatures inhibits the complex, which is a raw material compound from being decomposed, and inhibits an impurity from being contaminated into a thin film to be formed.

The atomic layer deposition disclosed herein is carried out, for example, using a film deposition apparatus such as the apparatus shown in Figure 1. In a film deposition chamber 1, the raw material compound vaporized in a raw material container 2 undergoes deposition processing in which it is deposited on a substrate preliminarily prepared, then to deposit the raw material compound on the substrate. Thereafter, in the film deposition chamber 1, the deposit undergoes film deposition processing such that a thin film is deposited by reduction with reducing gas, then to form the thin film. It is to be noted that Figure 1 shows only one raw material container 2, however, it may be two or more, for example, when two or more raw material compounds are used. The film deposition apparatus will be specifically described below.

In the raw material container 2, a raw material liquid 25 containing a raw material compound is heated and vaporized, if necessary. The vaporized raw material compound is transported to the film deposition chamber 1 by inert carrier gas. In order to vaporize the raw material liquid, the raw material container 2 may have been heated to, for example,

30°C or higher, 45°C or higher, 200°C or lower, or 120°C or lower. The raw material compound may have alternatively been heated to 45°C to 120°C or 30°C to 200°C.

The inert carrier gas described above is, for example, nitrogen, argon, helium. The inert carrier gas is regulated for its flow rate using a mass flow controller (hereinafter also referred to as "MFC") 3. The pressure inside the raw material container 2 is adjusted using a needle valve 4. The flow rate of the inert carrier gas is, for example, 10 sccm to 100 sccm. The pressure inside the raw material container 2 is measured using a pressure gauge 26. The pressure value is, for example, 10 Torr to 100 Torr.

The raw material container 2 is connected to a line that branches into a supply line 5 leading to the film deposition chamber 1 and an exhaust line 6. The supply line 5 and exhaust line 6 have a valve 7 and a valve 8, respectively, which are opened and closed to switch between supply and exhaust of a raw material. The supply line 5 and exhaust line 6 may have a heating mechanism. Examples of the heating mechanism include a heater disposed around piping, typically a jacket heater.

The supply line 5 and exhaust line 6 can be purged with inert purge gas. Examples of the inert purge gas include nitrogen, argon, helium. The inert purge gas is regulated for its flow rate by an MFC 9. The flow rate of the inert purge gas is, for example, 10 sccm to 100 sccm. The purge destination is switched to the supply line 5 or the exhaust line 6 by opening and closing the valve 10 and the valve 11, respectively. A sequence is set such that when a raw material compound flows through the supply line 5, the inert purge gas flows through the exhaust line 6, and when the raw material compound flows through the exhaust line 6, the inert purge gas flows through the supply line 5.

When reactant gas is high-pressure gas such as hydrogen or oxygen, it is supplied with regulation on its flow rate using a MFC 12. The flow rate is, for example, 10 sccm to 1,000 sccm. When the reactant gas is liquid at normal temperature and pressure, such as water or formic acid, it is supplied using the inert carrier gas, as with the raw material compound.

A supply line for the reactant gas branches into a supply line 13 which leads to the film deposition chamber 1, and an exhaust line 14. The supply line 13 and exhaust line 14 have a valve 15 and a valve 16, respectively, and supply of the reducing gas and exhaust thereof are switched by opening and closing the valve 15 and the valve 16, respectively. The supply line 13 and exhaust line 14 may have a heating mechanism. Examples of the heating mechanism include a heater disposed around piping, typically a jacket heater.

The supply line 13 and exhaust line 14 can be purged with the inert purge gas. Examples of the inert purge gas include nitrogen, argon, helium. The flow rate of the inert purge gas is adjusted by the MFC 17. The flow rate of the inert purge gas is, for example, 10 sccm to 100 sccm. The purge destination is switched to the supply line 13 or the exhaust line 14 by opening and closing a valve 18 and a valve 19, respectively. A sequence is set so that when the reactant gas flows through the supply line 13, the inert purge gas flows into the exhaust line 14, and when the reactant gas flows through the exhaust line 14, the inert purge gas flows into the supply line 13.

An inert balance gas line for adjusting a flow rate may be connected to the film deposition chamber 1. Examples of the inert balance gas include nitrogen, argon, helium. The inert balance gas is regulated for its flow rate using an MFC 20. The flow rate of the inert balance gas is, for example, 10 sccm to 100 sccm.

The film deposition chamber 1 is equipped with a film deposition stage 21. Before introduced with raw material compounds, the film deposition stage 21 typically contact the second main surface of a substrate on which a film is to be deposited. The second main surface of the substrate is the surface of the opposite side of the first main surface.

In the film deposition chamber 1, the raw material compound vaporized in the raw material container 2 is introduced. That is, the vaporized raw material compound comes into contact with the first main surface of the above-described substrate, and undergo film deposition processing such that the vaporized raw material compound is deposited on the substrate.

In the film deposition chamber 1, following the deposition processing, the deposit is reacted with the reactant gas to undergo film deposition processing such that the deposit forms a thin film.

The film deposition chamber 1 may be equipped with a heating mechanism, and it is, for example, heated to 100°C to 300°C.

The film deposition chamber 1 has a discharge line 22 for discharging gas. The discharge line 22 discharges the raw material compound, carrier gas, reducing gas, and the like, which remain in the film deposition chamber 1. Examples of the method for discharging them include a method for purging the system with inert gas such as nitrogen or argon, a method for discharging them by reducing the pressure inside the system, or a combination of these methods.

The discharge line 22 is equipped with a butterfly valve 23 for adjusting a pressure in the film deposition chamber 1. The film deposition chamber 1 is regulated for its pressure by the opening of the butterfly valve 23, and the pressure in the film deposition chamber 1 is, for example, 10 Torr to 30 Torr.

The discharge line 22 is connected to the exhaust line 6 and the exhaust line 14 downstream of the butterfly valve 23 (i.e., in the opposite direction to the film deposition chamber 1). The discharge line 22 has a pump 24 downstream of a connection point with the exhaust line 6 and the exhaust line 14.

As described above, the raw material liquid 25 containing the raw material compound is present in the raw

material container 2, and the raw material compound vaporized in the raw material container 2 is transported by the carrier gas through the supply line 5 to the film deposition chamber 1. In the film deposition chamber 1, the raw material compound vaporized in the raw material container 2 is deposited on a substrate preliminarily prepared. Thereafter, the deposit is reacted with the reactant gas to form a thin film in the film deposition chamber 1. This procedure is repeated a specified number of times to obtain a thin film of the desired thickness.

Before introduced with the raw material compound, the above-described substrate is typically disposed on a film deposition stage installed in the film deposition chamber 1.

The material constituting the above-described substrate is not limited, and examples thereof include metals such as copper, silver, gold, platinum, nickel, palladium, and aluminum; silicon; ceramics such as indium arsenide, indium gallium arsenide, silicon oxide, silicon nitride, silicon carbide, titanium nitride, tantalum oxide, tantalum nitride, titanium oxide, titanium nitride, ruthenium oxide, zirconium oxide, hafnium oxide, lanthanum oxide, and gallium nitride; and glass.

In one embodiment, the material constituting the above-described substrate is copper, silver, gold, platinum, nickel, palladium, or aluminum, preferably copper.

The shape of the above-described substrate is not limited, and may be, for example, platy, rod-like, spherical, layer-like, fibrous, flaky.

In one embodiment, the shape of the substrate may be a layer provided on a substrate, such as wiring on a wiring board.

A temperature of a substrate upon depositing the raw material compound on the substrate may be, for example, 20 to 300°C, preferably 50 to 200°C, more preferably 80 to 180°C, and still more preferably 100 to 160°C.

According to the atomic layer deposition of the present disclosure, a thin film that is contaminated with less amount of impurity can be deposited. Therefore, the atomic layer deposition of the present disclosure can be suitably used, for example, in manufacturing of semiconductor substrates.

(Method for Selecting Raw Material Complex for Use in Atomic Layer Deposition)

The present disclosure provides a method for selecting a raw material complex for use in an atomic layer deposition, comprising selecting the raw material complex which has (i) a central metal having an atomic polarizability of 45 to 51,

a polarizability volume of 200 or less,
a relative dielectric constant of 2.20 or less, and
a surface charge density such that an area having a surface charge density of 0.007 e/Å$^2$ or more is 10% or less with respect to an entire molecular area, or an area having a surface charge density of -0.007 e/Å$^2$ or less is 10% or less with respect to an entire molecular area, or
the raw material complex which has
(ii) a central metal having an atomic polarizability of 52 to 90,
a polarizability volume of 220 or less,
a relative dielectric constant of 2.50 or less, and
a surface charge density such that an area having a surface charge density of 0.007 e/Å$^2$ or more is 10% or less with respect to an entire molecular area, or an area having a surface charge density of -0.007 e/Å$^2$ or less is 10% or less with respect to an entire molecular area.

According to the method for selecting a complex disclosed herein, a complex having a high vapor pressure can be found.

(i) In the Case of Central Metal Having Atomic Polarizability of 45 to 51

In the method for selecting a complex disclosed herein, the complex having a polarizability volume of 200 or less, for example, 190 or less, 180 or less, 170 or less, 160 or less, 150 or less, 140 or less, 130 or less, 125 or less, or 120 or less, is selected. Also, the complex having a polarizability volume of, for example, 10 or more, 30 or more, 50 or more, 60 or more, 70 or more, or 80 or more, is selected.

In the method for selecting a complex disclosed herein, the complex having a relative dielectric constant of 2.20 or less, for example, 2.10 or less, 2.00 or less, 1.90 or less, 1.80 or less, 1.70 or less, or 1.60 or less, is selected. Also, the complex having a relative dielectric constant of, for example, 1.10 or more, 1.20 or more, 1.30 or more, 1.40 or more, or 1.50 or more, is selected.

(ii) In the Case of Central Metal Having Atomic Polarizability of 52 to 90

In the method for selecting a complex disclosed herein, the complex having a polarizability volume of 240 or less, for example, 234 or less, 230 or less, 220 or less, 210 or less, 200 or less, 190 or less, or 180 or less, is selected. Also, the complex having a polarizability volume of, for example, 10 or more, 30 or more, 50 or more, 60 or more, 70 or more, or 80 or more, is selected.

In the method for selecting a complex disclosed herein, the complex having a relative dielectric constant of 2.50 or less, for example, 2.40 or less, 2.36 or less, 2.30 or less, 2.00 or less, 1.90 or less, 1.80 or less, 1.70 or less, or 1.60 or less, is selected. Also, the complex having a relative dielectric constant of, for example, 1.10 or more, 1.20 or more, 1.30 or more, 1.40 or more, or 1.50 or more, is selected.

In the method for selecting a complex disclosed herein, a complex having a surface charge density such that an area having a surface charge density of 0.007 e/$Å^2$ or more is 10% or less with respect to the entire molecular area, or a complex having a surface charge density such that an area having a surface charge density of -0.007 e/$Å^2$ or less is 10% or less with respect to the entire molecular area, is selected.

In one embodiment, the complex has a surface charge density such that an area having a surface charge density of 0.007 e/$Å^2$ or more is preferably 10% or less, more preferably 5% or less, and still more preferably 3% or less, with respect to the entire molecular area.

In one embodiment, the complex has a surface charge density such that an area having a surface charge density of -0.007 e/$Å^2$ or less is preferably 10% or less, more preferably 5% or less, and still more preferably 3% or less, with respect to the entire molecular area.

In one embodiment, the complex has a surface charge density such that an area of having a surface charge density 0.007 e/$Å^2$ or more is preferably 10% or less, more preferably 5% or less, and still more preferably 3% or less, with respect to the entire molecular area, and the area having a surface charge density of -0.007 e/$Å^2$ or less is preferably 10% or less, more preferably 5% or less, and still more preferably 3% or less, with respect to the entire molecular area.

(i) In the Case of Central Metal Having Atomic Polarizability of 45 to 51

In the method for selecting a complex disclosed herein, the complex having a vapor pressure at 100°C of preferably 1.0 Torr or more, more preferably 2.0 Torr or more, and still more preferably 3.0 Torr or more, for example, 3.5 or 4.5 Torr or more, 5.5 Torr or more, 6.0 Torr or more, 6.3 Torr or more, or 6.7 Torr or more, is selected. Also, the complex having a vapor pressure at 100°C of, for example, 55 Torr or less, 50 Torr or less, 45 Torr or less, 40 Torr or less, 35 Torr or less, 30 Torr or less, 25 Torr or less, 20 Torr or less, 15 Torr or less, 10 Torr or less, 8 Torr or less, 7 Torr or less, or 6 Torr or less, is selected.

(ii) In the Case of Central Complex Having Atomic Polarizability of 52 to 90

In the method for selecting a complex disclosed herein, the complex having a vapor pressure at 100°C of preferably 0.6 Torr or more, more preferably 1.0 Torr or more, still more preferably 2.0 Torr or more, and even still more preferably 2.8 Torr or more, for example, 3.0 Torr or more, 3.5 Torr or more, 3.6 Torr or more, 4.5 Torr or more, or 5.5 Torr or more, is selected. Also the complex having a vapor pressure at 100°C of, for example, 10 Torr or less, 8 Torr or less, 7 Torr or less, or 6 Torr or less, is selected.

The complex having a polarizability volume, a relative dielectric constant, a surface charge density, and a vapor pressure within the above ranges has a high vapor pressure and can be vaporized at a relatively low temperature.

In one embodiment of the method for selecting a complex disclosed herein:

(i) In the Case of Central Metal Having Atomic Polarizability of 45 to 51

The complex that satisfies the following conditions is selected:

a polarizability volume ≤ 180 and a relative dielectric constant ≤ 2.00;

a polarizability volume ≤ 170 and a relative dielectric constant ≤ 1.90;

a polarizability volume ≤ 160 and a relative dielectric constant ≤ 1.80;

a polarizability volume ≤ 125 and a relative dielectric constant ≤ 2.20;

a polarizability volume ≤ 120 and a relative dielectric constant ≤ 2.20;

or

a polarizability volume ≤ 120 and a relative dielectric constant ≤ 2.00.

In one embodiment of the method for selecting a complex disclosed herein:

(ii) In the Case of Central Metal Having Atomic Polarizability of 52 to 90

The complex that satisfies the following conditions is selected:

a polarizability volume ≤ 220 and a relative dielectric constant ≤ 2.50;

a polarizability volume ≤ 234 and a relative dielectric constant ≤ 2.36;

a polarizability volume ≤ 200 and a relative dielectric constant ≤ 2.40;

or

a polarizability volume ≤ 180 and a relative dielectric constant ≤ 2.30.

The polarizability volume and relative dielectric constant described above can be determined by simulation.

Examples of the above-described simulation include a COSMO-SAC (Conductor-like Screening Model-Segment Activity Coefficient) method or a DFT (Density Functional Theory) method. The COSMO-SAC method and the DFT method have the same meanings as above.

In the method for selecting a complex as disclosed herein, the complex whose central metal is preferably cobalt, ruthenium, tungsten, copper, palladium, or molybdenum, more preferably cobalt, ruthenium, tungsten, palladium, or molybdenum, still more preferably cobalt, ruthenium, or tungsten, and particularly preferably cobalt, is selected. In a preferred embodiment, cobalt, nickel, or copper is selected as a central metal having an atomic polarizability of 45 to 51. In another preferred embodiment, molybdenum, ruthenium, or tungsten is selected as a central metal having an atomic polarizability of 52 to 90. The complexes having such central metals may have a higher vapor pressure.

Examples

The present disclosure will be described below by way of Examples, but the present disclosure is not limited to the following Examples.

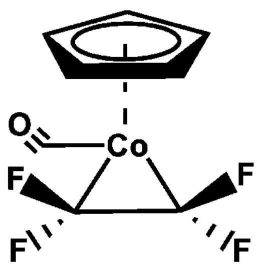

(Example 1)

In a glove box, an autoclave with a 30 mL glass inner tube was charged with CpCo(CO)2 (300 mg), NaI (49.35 mg), and dry THF (15 mL), and following gentle stirring, a septum cap was attached. The autoclave was then transferred from the glove box to a draft chamber and trifluoromethyltrimethylsilane (600 mg) was slowly added dropwise with a syringe into the autoclave. The autoclave was closed with a lid and placed in an oil bath, and the contents were heated and stirred at a bath temperature of 65°C. After 2 hours, the heating was stopped. The reaction liquid left to be cooled was concentrated under reduced pressure, and to the resulting residue was added dry hexane (12 mL). The insoluble was

removed by filtration through Celite, and the filtrate was concentrated under reduced pressure, yielding 150 mg of a viscous brown liquid (yield: 36%). The results of IR analysis and NMR analysis were compared with those of literature values to confirm that the product obtained was the target compound, and was then analyzed by TG-DTA. The results are shown in Figure 4.

The level of a vapor pressure of a compound correlates with a Td50 temperature in TG-DTA, and a complex with a low Td50 temperature can be said to have a high vapor pressure.

For the above-described complex, the polarizability volume, relative dielectric constant, and surface charge density of the complex were calculated using the DFT method, and the vapor pressure of the complex was calculated using an improved COSMO-SAC method.

[Table 1]

| | |
|---|---|
| Polarizability volume | |
| Relative dielectric constant | |
| Surface charge density | The area having a surface charge density of 0.007 e/Å$^2$ or more is 0% with respect to the entire molecular area.<br>The area having a surface charge density of 0.007 e/Å$^2$ or less is 14% with respect to the entire molecular area. |
| Vapor pressure at 100°C | 65 Torr |
| Td50 | 150°C or less |

The vapor pressure of the above-described complex at 100°C was actually measured and found to be 153 Torr. The comparison of the experimental value and the calculated value confirmed that the values fell within the range of the 99% confidence interval in Rev. 3 in Figure 2.

(Example 2)

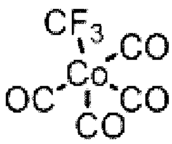

For the above-described complex, the polarizability volume, relative dielectric constant, and surface charge density of the complex were calculated using the DFT method, and the vapor pressure of the complex was calculated using an improved COSMO-SAC method.

[Table 2]

| | |
|---|---|
| Polarizability volume | 99.26 |
| Relative dielectric constant | 1.96 |
| Surface charge density | The area having a surface charge density of 0.007 e/Å$^2$ or more is 0% with respect to the entire molecular area.<br>The area having a surface charge density of 0.007 e/Å$^2$ or less is 5% with respect to the entire molecular area. |
| Vapor pressure at 100°C | 138 Torr |

(Example 3)

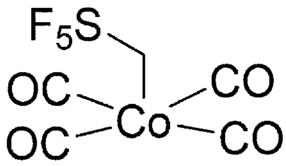

For the above-described complex, the polarizability volume, relative dielectric constant, and surface charge density of the complex were calculated using the DFT method, and the vapor pressure of the complex was calculated using an improved COSMO-SAC method.

[Table 3]

| | |
|---|---|
| Polarizability volume | 125.07 |
| Relative dielectric constant | 1.97 |
| Surface charge density | The area having a surface charge density of 0.007 e/Å$^2$ or more is 0% with respect to the entire molecular area.<br>The area having a surface charge density of 0.007 e/Å$^2$ or less is 8% with respect to the entire molecular area. |
| Vapor pressure at 100°C | 65 Torr |

(Example 4)

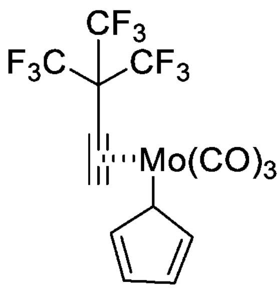

For the above-described complex, the polarizability volume, relative dielectric constant, and surface charge density of the complex were calculated using the DFT method, and the vapor pressure of the complex was calculated using an improved COSMO-SAC method.

[Table 4]

| | |
|---|---|
| Polarizability volume | 195.3 |
| Relative dielectric constant | 2.04 |
| Surface charge density | The area having a surface charge density of 0.007 e/Å$^2$ or more is 0.1% with respect to the entire molecular area.<br>The area having a surface charge density of 0.007 e/Å$^2$ or less is 10% with respect to the entire molecular area. |
| Vapor pressure at 100°C | 5.5 Torr |

(Example 5)

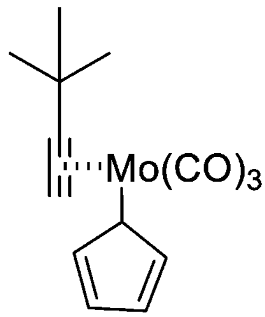

For the above-described complex, the polarizability volume, relative dielectric constant, and surface charge density of the complex were calculated using the DFT method, and the vapor pressure of the complex was calculated using an improved COSMO-SAC method.

[Table 5]

| | |
|---|---|
| Polarizability volume | 194.33 |
| Relative dielectric constant | 2.36 |
| Surface charge density | The area having a surface charge density of 0.007 e/Å$^2$ or more is 7.0% with respect to the entire molecular area.<br>The area having a surface charge density of 0.007 e/Å$^2$ or less is 9.0% with respect to the entire molecular area. |
| Vapor pressure at 100°C | 3.0 Torr |

(Example 6)

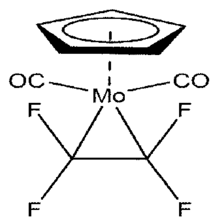

For the above-described complex, the polarizability volume, relative dielectric constant, and surface charge density of the complex were calculated using the DFT method, and the vapor pressure of the complex was calculated using an improved COSMO-SAC method.

[Table 6]

| | |
|---|---|
| Polarizability volume | 148.60 |
| Relative dielectric constant | 2.17 |
| Surface charge density | The area having a surface charge density of 0.007 e/Å$^2$ or more is 0% with respect to the entire molecular area. |

(continued)

| | |
|---|---|
| | The area having a surface charge density of 0.007 e/Å$^2$ or less is 13% with respect to the entire molecular area. |
| Vapor pressure at 100°C | 1.3 Torr |

(Example 7)

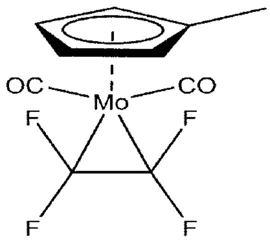

For the above-described complex, the polarizability volume, relative dielectric constant, and surface charge density of the complex were calculated using the DFT method, and the vapor pressure of the complex was calculated using an improved COSMO-SAC method.

[Table 7]

| | |
|---|---|
| Polarizability volume | 162.00 |
| Relative dielectric constant | 2.18 |
| Surface charge density | The area having a surface charge density of 0.007 e/Å$^2$ or more is 0% with respect to the entire molecular area.<br>The area having a surface charge density of 0.007 e/Å$^2$ or less is 11% with respect to the entire molecular area. |
| Vapor pressure at 100°C | 0.61 Torr |

(Example 8)

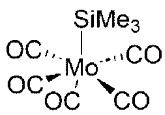

For the above-described complex, the polarizability volume, relative dielectric constant, and surface charge density of the complex were calculated using the DFT method, and the vapor pressure of the complex was calculated using an improved COSMO-SAC method.

[Table 8]

| | |
|---|---|
| Polarizability volume | 234.60 |
| Relative dielectric constant | 2.44 |

(continued)

| | |
|---|---|
| Surface charge density | The area having a surface charge density of 0.007 e/Å$^2$ or more is 0% with respect to the entire molecular area.<br>The area having a surface charge density of 0.007 e/Å$^2$ or less is 3% with respect to the entire molecular area. |
| Vapor pressure at 100°C | 0.73 Torr |

(Example 9)

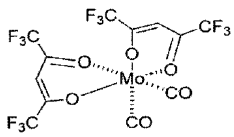

For the above-described complex, the polarizability volume, relative dielectric constant, and surface charge density of the complex were calculated using the DFT method, and the vapor pressure of the complex was calculated using an improved COSMO-SAC method.

[Table 9]

| | |
|---|---|
| Polarizability volume | 234.16 |
| Relative dielectric constant | 2.06 |
| Surface charge density | The area having a surface charge density of 0.007 e/Å$^2$ or more is 0.2% with respect to the entire molecular area.<br>The area having a surface charge density of 0.007 e/Å$^2$ or less is 7% with respect to the entire molecular area. |
| Vapor pressure at 100°C | 2.1 Torr |

(Comparative Example 1)

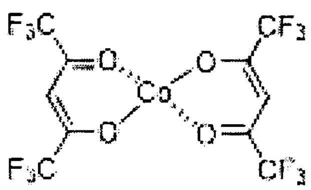

$Co(CF_3\text{-}acac)_2$

The above-described complex underwent a TG-DTA analysis. The results are shown in Figure 6.

For the above-described complex, the polarizability volume, relative dielectric constant, and surface charge density of the complex were calculated using the DFT method, and the vapor pressure of the complex was calculated using an improved COSMO-SAC method.

[Table 10]

| | |
|---|---|
| Polarizability volume | 245.00 |

(continued)

| | |
|---|---|
| Relative dielectric constant | 1.87 |
| Surface charge density | The area having a surface charge density of 0.007 e/Å$^2$ or more is 4% with respect to the entire molecular area.<br>The area having a surface charge density of 0.007 e/Å$^2$ or less is 9% with respect to the entire molecular area. |
| Vapor pressure at 150°C | 9 Torr |
| Vapor pressure at 100°C | 5.5 Torr |
| Td50 | 175 1°C |

(Comparative Example 2)

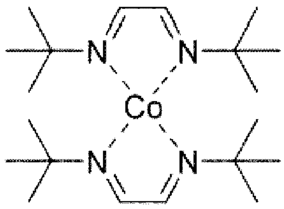

The above-described complex underwent a TG-DTA analysis.

For the above-described complex, the polarizability volume, relative dielectric constant, and surface charge density of the complex were calculated using the DFT method, and the vapor pressure of the complex was calculated using an improved COSMO-SAC method.

[Table 11]

| | |
|---|---|
| Polarizability volume | 364.00 |
| Relative dielectric constant | 2.61 |
| Surface charge density | The area having a surface charge density of 0.007 e/Å$^2$ or more is 4% with respect to the entire molecular area.<br>The area having a surface charge density of 0.007 e/Å$^2$ or less is 1% with respect to the entire molecular area. |
| Vapor pressure at 110°C | 0.1 Torr |
| Td50 | 275°C |

(Comparative Example 3)

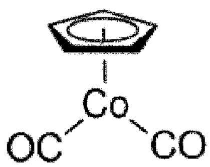

For the above-described complex, the polarizability volume, relative dielectric constant, and surface charge density of the complex were calculated using the DFT method, and the vapor pressure of the complex was calculated using an improved COSMO-SAC method.

[Table 12]

| | |
|---|---|
| Polarizability volume | 107.7 |
| Relative dielectric constant | 2.31 |
| Surface charge density | The area having a surface charge density of 0.007 e/Å$^2$ or more is 4% with respect to the entire molecular area.<br>The area having a surface charge density of 0.007 e/Å$^2$ or less is 14% with respect to the entire molecular area. |
| Vapor pressure at 25°C | 0.34 Torr |

(Comparative Example 4)

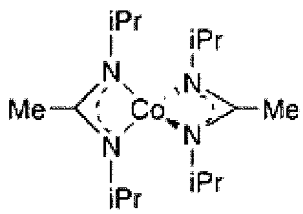

For the above-described complex, the polarizability volume, relative dielectric constant, and surface charge density of the complex were calculated using the DFT method, and the vapor pressure of the complex was calculated using an improved COSMO-SAC method.

[Table 13]

| | |
|---|---|
| Polarizability volume | 259.0 |
| Relative dielectric constant | 2.18 |
| Surface charge density | The area having a surface charge density of 0.007 e/Å$^2$ or more is 4% with respect to the entire molecular area.<br>The area having a surface charge density of 0.007 e/Å$^2$ or less is 0.5% with respect to the entire molecular area. |
| Vapor pressure at 100°C | 1.2 Torr |

(Comparative Example 5)

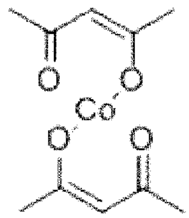

For the above-described complex, the polarizability volume, relative dielectric constant, and surface charge density of the complex were calculated using the DFT method, and the vapor pressure of the complex was calculated using an improved COSMO-SAC method.

[Table 14]

| | |
|---|---|
| Polarizability volume | 174.4 |
| Relative dielectric constant | 2.31 |
| Surface charge density | The area having a surface charge density of 0.007 e/$Å^2$ or more is 13% with respect to the entire molecular area.<br>The area having a surface charge density of 0.007 e/$Å^2$ or less is 9% with respect to the entire molecular area. |
| Vapor pressure at 150°C | 4.7 Torr |

(Comparative Example 6)

Ni(tBu-AMD)2

For the above-described complex, the polarizability volume, relative dielectric constant, and surface charge density of the complex were calculated using the DFT method, and the vapor pressure of the complex was calculated using an improved COSMO-SAC method.

[Table 15]

| | |
|---|---|
| Polarizability volume | 303.7 |
| Relative dielectric constant | 2.2 |
| Surface charge density | The area having a surface charge density of 0.007 e/$Å^2$ or more is 3% with respect to the entire molecular area.<br>The area having a surface charge density of 0.007 e/$Å^2$ or less is 2% with respect to the entire molecular area. |
| Vapor pressure at 90°C | 0.004 Torr |

(Comparative Example 7)

Cu(iPr-AMD)2

For the above-described complex, the polarizability volume, relative dielectric constant, and surface charge

density of the complex were calculated using the DFT method, and the vapor pressure of the complex was calculated using an improved COSMO-SAC method.

[Table 16]

| | |
|---|---|
| Polarizability volume | 275.4 |
| Relative dielectric constant | 2.3 |
| Surface charge density | The area having a surface charge density of 0.007 e/Å$^2$ or more is 7.1% with respect to the entire molecular area.<br>The area having a surface charge density of 0.007 e/Å$^2$ or less is 1.7% with respect to the entire molecular area. |
| Vapor pressure at 100°C | 0.04 Torr |

(Comparative Example 8)

Mo (hfac) 3

For the above-described complex, the polarizability volume, relative dielectric constant, and surface charge density of the complex were calculated using the DFT method, and the vapor pressure of the complex was calculated using an improved COSMO-SAC method.

[Table 17]

| | |
|---|---|
| Polarizability volume | 293.60 |
| Relative dielectric constant | 2.70 |
| Surface charge density | The area having a surface charge density of 0.007 e/Å$^2$ or more is 12.0% with respect to the entire molecular area.<br>The area having a surface charge density of 0.007 e/Å$^2$ or less is 8.0% with respect to the entire molecular area. |
| Vapor pressure at 100°C | 0.003 Torr |

(Comparative Example 9)

Mo(Me-AMD)3

For the above-described complex, the polarizability volume, relative dielectric constant, and surface charge density of the complex were calculated using the DFT method, and the vapor pressure of the complex was calculated using an improved COSMO-SAC method.

[Table 18]

| | |
|---|---|
| Polarizability volume | 241.04 |
| Relative dielectric constant | 2.29 |

(continued)

| | |
|---|---|
| Surface charge density | The area having a surface charge density of 0.007 e/Å$^2$ or more is 7.0% with respect to the entire molecular area.<br>The area having a surface charge density of 0.007 e/Å$^2$ or less is 7.0% with respect to the entire molecular area. |
| | 0.01 Torr |

(Comparative Example 10)

Mo(iPr-AMD)3

For the above-described complex, the polarizability volume, relative dielectric constant, and surface charge density of the complex were calculated using the DFT method, and the vapor pressure of the complex was calculated using an improved COSMO-SAC method.

[Table 19]

| | |
|---|---|
| Polarizability volume | 377.80 |
| Relative dielectric constant | 2.2 |
| Surface charge density | The area having a surface charge density of 0.007 e/Å$^2$ or more is 0.2% with respect to the entire molecular area.<br>The area having a surface charge density of 0.007 e/Å$^2$ or less is 0.2% with respect to the entire molecular area. |
| Vapor pressure at 100°C | 0.01 Torr |

(Comparative Example 11)

Ru(iPr-AMD)3

For the above-described complex, the polarizability volume, relative dielectric constant, and surface charge density of the complex were calculated using the DFT method, and the vapor pressure of the complex was calculated using an improved COSMO-SAC method.

[Table 20]

| | |
|---|---|
| Polarizability volume | 403.0 |
| Relative dielectric constant | 2.32 |
| Surface charge density | The area having a surface charge density of 0.007 e/Å$^2$ or more is 0.3% with respect to the entire molecular area.<br>The area having a surface charge density of 0.007 e/Å$^2$ or less is 0.5% with respect to the entire molecular area. |
| Vapor pressure at 100°C | 0.003 Torr |

(Comparative Example 12)

W(iPr-AMD)3

For the above-described complex, the polarizability volume, relative dielectric constant, and surface charge density of the complex were calculated using the DFT method, and the vapor pressure of the complex was calculated using an improved COSMO-SAC method.

[Table 21]

| | |
|---|---|
| Polarizability volume | 379.8 |
| Relative dielectric constant | 2.23 |
| Surface charge density | The area having a surface charge density of 0.007 e/Å$^2$ or more is 0% with respect to the entire molecular area.<br>The area having a surface charge density of 0.007 e/Å$^2$ or less is 0.5% with respect to the entire molecular area. |
| Vapor pressure at 100°C | 0.01 Torr |

Industrial Applicability

According to the complex disclosed herein, ALD enables a high-purity thin film to be efficiently deposited. Therefore, the complex and the atomic layer deposition of the present disclosure are suitably used for a variety of applications, such as manufacturing of semiconductor substrates.

Reference Signs List

1 film deposition chamber
2 raw material container
3, 9, 12, 17, 20 mass flow controller
4 needle valve
5, 13 supply line
6, 14 exhaust line
7, 8, 10, 11, 15, 16, 18, 19 valves
21 film deposition stage
22 discharge line
23 butterfly valve
24 pump
25 liquid raw material
26, 27 pressure gauge

## Claims

**1.** A raw material complex for forming a thin metal film, having a central metal and a ligand coordinated to the central metal,
wherein the central metal has an atomic polarizability of 45 to 51 and the complex satisfies the following conditions:

$$\text{a polarizability volume} \leq 200$$

and

$$\text{a relative dielectric constant} \leq 2.20.$$

**2.** A raw material complex for forming a thin metal film, having a central metal and a ligand coordinated to the central metal,
wherein the central metal has an atomic polarizability of 52 to 90 and the complex satisfies the following conditions:

$$\text{a polarizability volume} \leq 240$$

and

$$\text{a relative dielectric constant} \leq 2.50.$$

**3.** The raw material complex for forming a thin metal film according to claim 1 or 2, satisfying that an area having a surface charge density of 0.007 e/Å$^2$ or more is 10% or less with respect to an entire complex molecular area, or an area having a surface charge density of -0.007 e/Å$^2$ or less is 10% or less with respect to an entire complex molecular area.

**4.** The raw material complex for forming a thin metal film according to claim 1 or 2, wherein the ligand is a monodentate ligand, a polydentate ligand, or both thereof.

**5.** The raw material complex for forming a thin metal film according to claim 1 or 2, wherein an atom that coordinates with a metal in the ligand has a Pauling electronegativity of 3.1 or less.

**6.** The raw material complex for forming a thin metal film according to claim 1 or 2, wherein the ligand has at least one branched alkyl group having three or more carbon atoms.

**7.** The raw material complex for forming a thin metal film according to claim 4, wherein the monodentate ligand is carbonyl, alkyne, alkyl, fluoroalkyl, allyl, aminoalkyl, hydride, or alkylsilane.

**8.** The raw material complex for forming a thin metal film according to claim 4, wherein the polydentate ligand is a bidentate ligand, and the bidentate ligand is alkyldiene, cyclopentadiene, acetylacetonate, alkyldiamine, or alkyldisilane.

**9.** The raw material complex for forming a thin metal film according to claim 4, wherein the polydentate ligand is a tridentate ligand, and the tridentate ligand is amidinate.

**10.** The raw material complex for forming a thin metal film according to claim 1 or 2, wherein the central metal has an oxidation number of 1 or greater.

**11.** The raw material complex for forming a thin metal film according to claim 1, wherein the central metal is cobalt, nickel, or copper.

**12.** The complex for forming a thin metal film according to claim 1, having a vapor pressure at 100°C of 6.0 Torr or more.

**13.** The complex for forming a thin metal film according to claim 1, wherein the central metal is cobalt and the complex has a vapor pressure at 100°C of 6.0 Torr or more.

**14.** The complex for forming a thin metal film according to claim 1, wherein the central metal is nickel and the complex has a vapor pressure at 100°C of 6.3 Torr or more.

**15.** The complex for forming a thin metal film according to claim 1, wherein the central metal is copper and the complex has a vapor pressure at 100°C of 6.7 Torr or more.

**16.** The raw material complex for forming a thin metal film according to claim 2, wherein the central metal is molybdenum, ruthenium, or tungsten.

17. The complex for forming a thin metal film according to claim 2, having a vapor pressure at 100°C of 0.6 Torr or more.

18. The complex for forming a thin metal film according to claim 2, wherein the central metal is molybdenum and the complex has a vapor pressure at 100°C of 0.6 Torr or more.

19. The complex for forming a thin metal film according to claim 2, wherein the central metal is ruthenium and the complex has a vapor pressure at 100°C of 2.8 Torr or more.

20. The complex for forming a thin metal film according to claim 2, wherein the central metal is tungsten and the complex has a vapor pressure at 100°C of 3.6 Torr or more.

21. The complex for forming a thin metal film according to claim 1 or 2 for use in an atomic layer deposition.

22. An atomic layer deposition, using the complex according to claim 1 or 2 as a raw material compound.

23. The atomic layer deposition according to claim 22, wherein a film deposition temperature upon film deposition using the complex according to claim 1 or 2 is 200°C or lower.

24. The atomic layer deposition according to claim 22 for use in production of semiconductor substrates.

25. A method for selecting a raw material complex for use in an atomic layer deposition, comprising selecting the raw material complex which has

a central metal having an atomic polarizability of 45 to 51,
a polarizability volume of 200 or less,
a relative dielectric constant of 2.20 or less, and
a surface charge density such that an area having a surface charge density of 0.007 e/$Å^2$ or more is 10% or less with respect to an entire molecular area, or an area having a surface charge density of -0.007 e/$Å^2$ or less is 10% or less with respect to an entire molecular area.

26. A method for selecting a raw material complex for use in an atomic layer deposition, comprising selecting the raw material complex which has

a central metal having an atomic polarizability of 52 to 90,
a polarizability volume of 220 or less,
a relative dielectric constant of 2.50 or less, and
a surface charge density such that an area having a surface charge density of 0.007 e/$Å^2$ or more is 10% or less with respect to an entire molecular area, or an area having a surface charge density of -0.007 e/$Å^2$ or less is 10% or less with respect to an entire molecular area.

27. The method according to claim 25, wherein the complex has a vapor pressure at 100°C of 1.0 Torr or more.

28. The method according to claim 25, wherein the central metal of the complex is cobalt, nickel, or copper.

29. The method according to claim 26, wherein the complex has a vapor pressure at 100°C is 0.6 Torr or more.

30. The method according to claim 26, wherein the central metal of the complex is molybdenum, ruthenium, or tungsten.

31. The method according to claim 25 or 26, wherein the polarizability volume, the relative dielectric constant, the surface charge density, and the vapor pressure of the complex are determined by simulation.

32. The method according to claim 31, wherein the simulation is at least one of a COSMO-SAC method, a DFT method, and an AMS method.

33. The method according to claim 32, wherein the COSMO-SAC method used in the simulation is a modified COSMO-SAC method.

FIG. 1

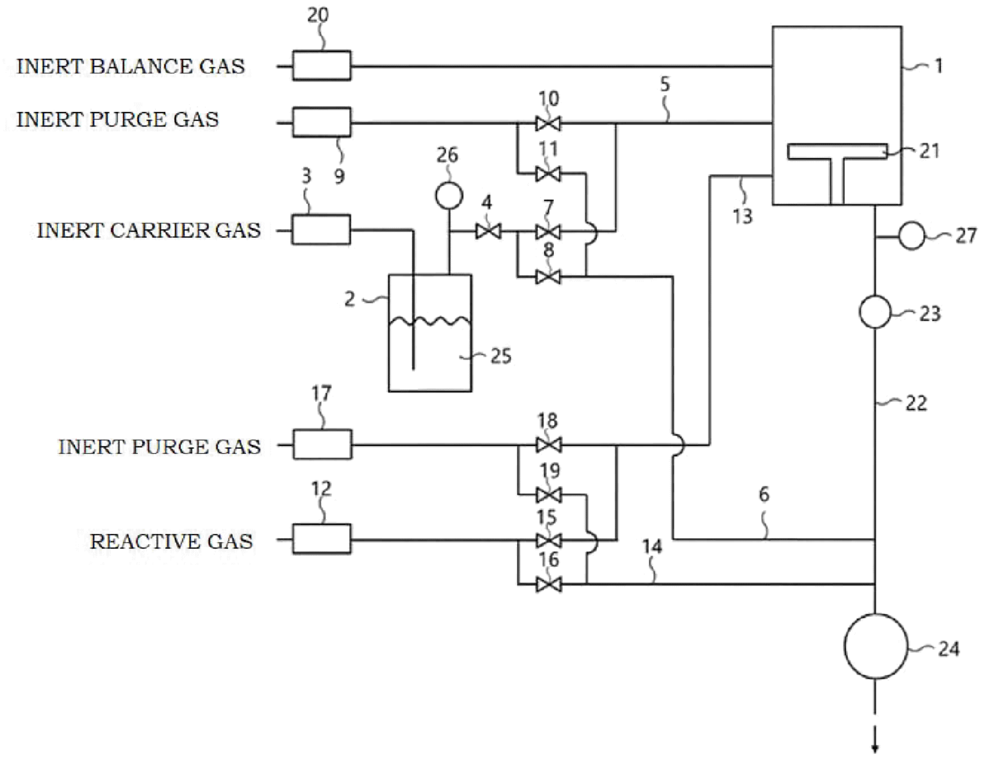
INERT BALANCE GAS
INERT PURGE GAS
INERT CARRIER GAS
INERT PURGE GAS
REACTIVE GAS
20
10
5
1
11
21
9
3
26
4
7
13
8
27
2
23
25
22
17
18
19
6
12
15
14
16
24

FIG. 2

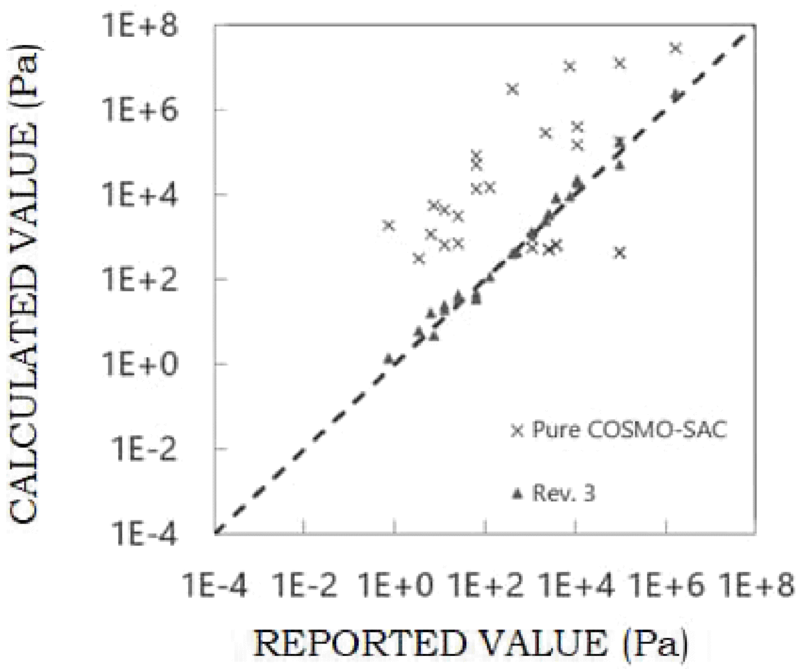
CALCULATED VALUE (Pa)
1E+8
1E+6
1E+4
1E+2
1E+0
1E-2
1E-4
× Pure COSMO-SAC
▲ Rev. 3
1E-4 1E-2 1E+0 1E+2 1E+4 1E+6 1E+8
REPORTED VALUE (Pa)

FIG. 3

| METAL COMPLEX | REPORTED VALUE | Pure COSMO-SAC CALCULATED VALUE (Pa) | Rev.3 CALCULATED VALUE (Pa) | TEMPERATURE |
|---|---|---|---|---|
| Co(hfac)3 | 1217.48 | 817.20 | 1267.90 | 150 |
| Fe(hfac)3 | 2553.37 | 447.05 | 3335.80 | 150 |
| Cr(hfac)3 | 3932.94 | 572.82 | 7239.26 | 150 |
| Cr(acac)3 | 101325.00 | 414.29 | 164393.06 | 150 |
| Mn(MeCP)(CO)3 | 6.67 | 1052.55 | 15.92 | 20 |
| Ni(MeCp) | 133.32 | 13760.31 | 112.65 | 85-90 |
| Co(EtCp)2 | 66.66 | 75244.66 | 32.24 | 74-78 |
| Fe(Cp)2 | 101325.00 | 11328109.12 | 164737.90 | 250 |
| Co(t-Bually)(CO)3 | 2266.44 | 265385.49 | 2350.51 | 86 |
| CCTBA | 11859.76 | 359077.41 | 17656.67 | 150 |
| Fe(CO)5 | 3.57 | 281.26 | 5.79 | 0 |
| Ni(CO)4 | 1630000.00 | 27496190.65 | 2404669.94 | 150 |
| CpCo(CO)2 | 66.66 | 13047.94 | 45.13 | 25 |
| Co2(CO)8 | 101325.00 | 151535.26 | 46546.91 | 95 |
| Co(CO)3NO | 11998.80 | 146920.22 | 20479.21 | 20 |
| Co(hfac)3 | 1217.48 | 546.43 | 1267.90 | 150 |
| Fe(hfac)3 | 2553.37 | 447.05 | 3335.80 | 150 |
| Cr(hfac)3 | 3932.94 | 572.82 | 7239.26 | 150 |
| Cr(acac)3 | 101325.00 | 414.29 | 164393.06 | 150 |
| CpCo(2iPr-MeAMD) | 0.80 | 1868.88 | 1.36 | 65 |
| TDEAT | 13.30 | 3933.88 | 20.95 | 112 |
| TDMAT | 66.70 | 46582.29 | 36.97 | 50 |
| Ni(tBu-AMD)2 | 26.66 | 627.33 | 32.29 | 90 |
| Co(amdtBuet) | 8.00 | 4995.68 | 4.56 | 110 |
| Ti(OPr)4 | 399.96 | 2881519.67 | 361.94 | 175 |
| Ti(OiPr)4 | 13.00 | 574.51 | 16.76 | 25 |
| Ti(OEt)4 | 8067.78 | 9740753.07 | 8174.15 | 175 |
| TTTB | 26.64 | 2881.78 | 40.45 | 70 |

[図4]

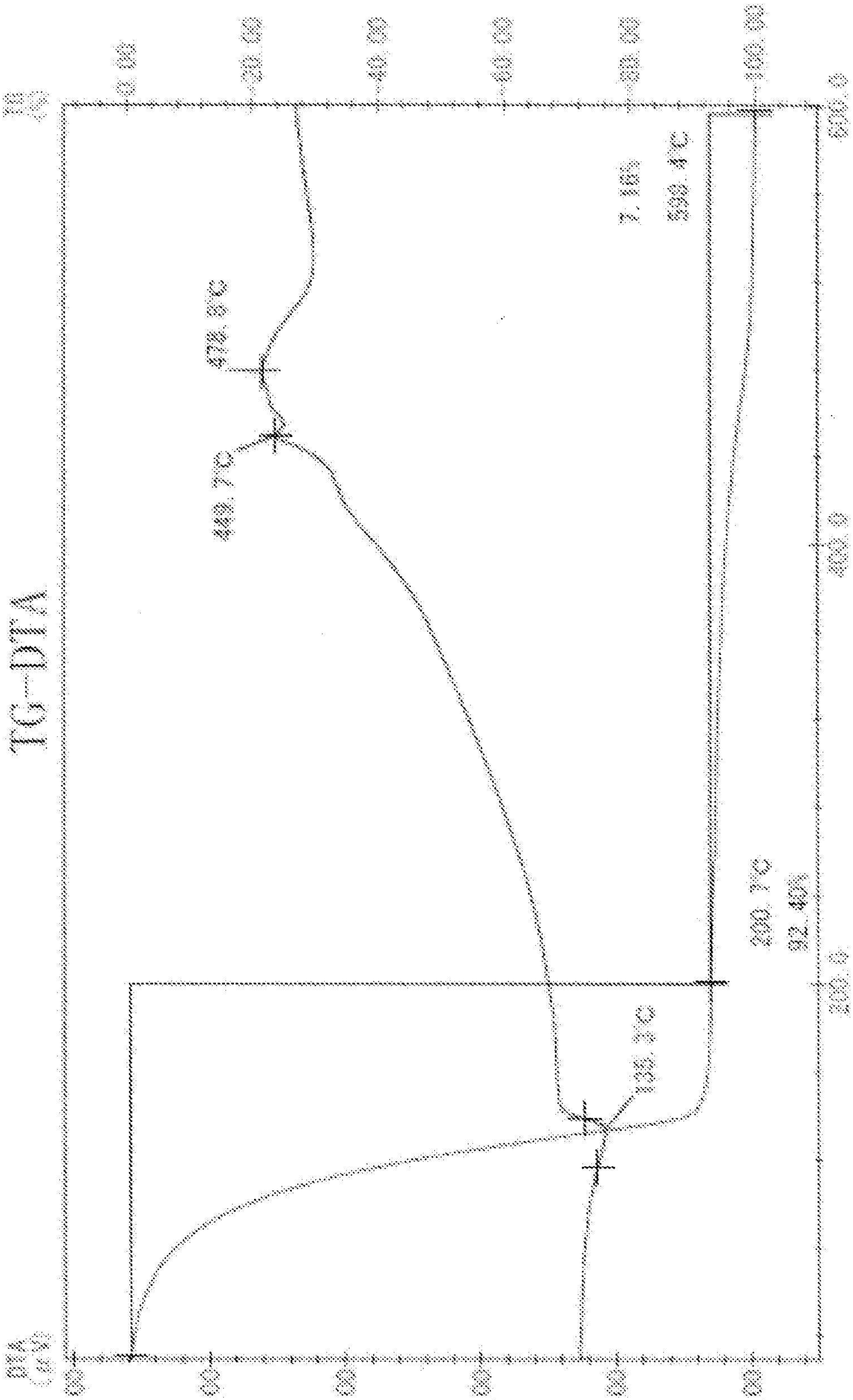

[図5]

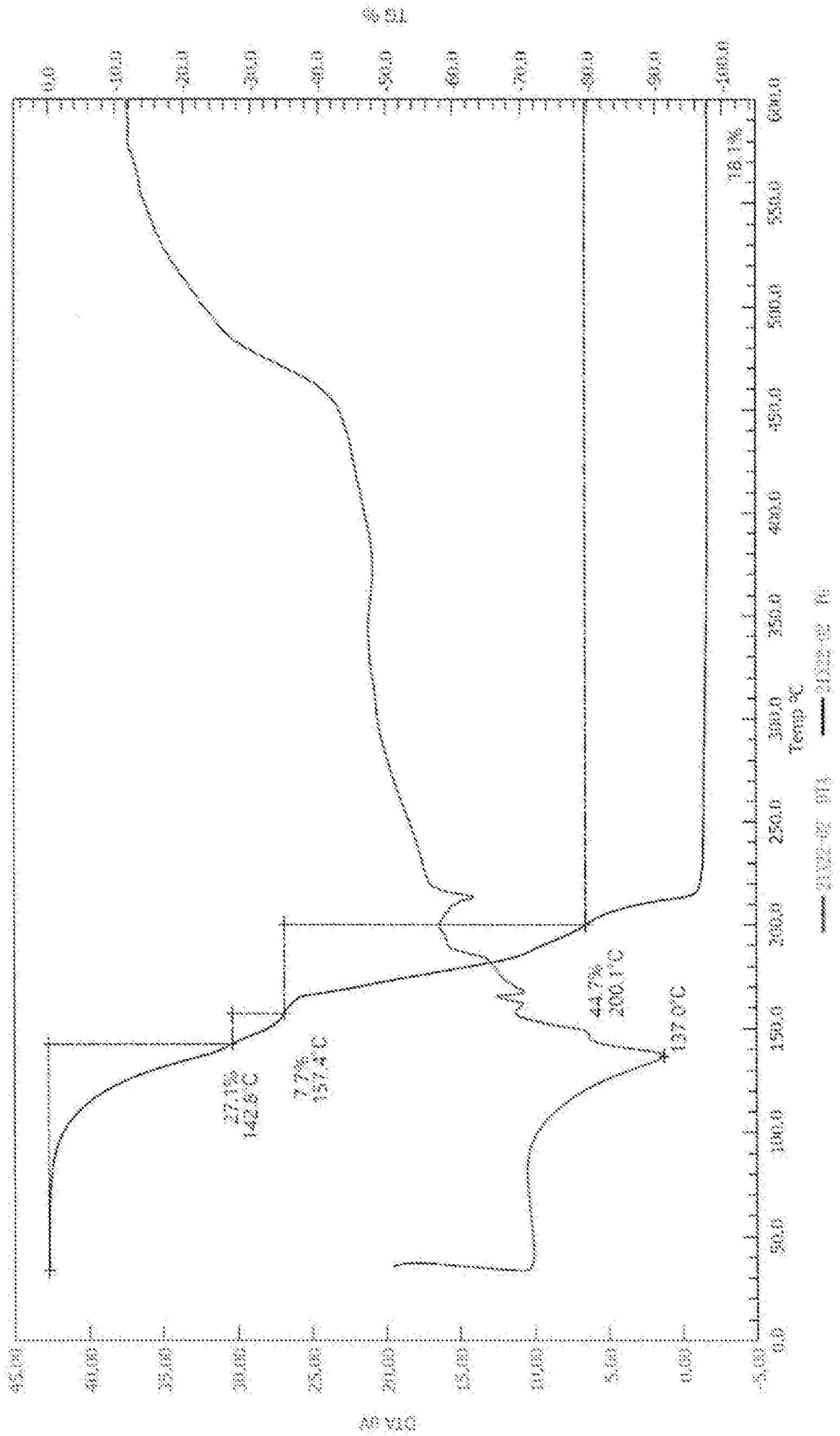

## INTERNATIONAL SEARCH REPORT

International application No.
**PCT/JP2024/030046**

### A. CLASSIFICATION OF SUBJECT MATTER

***C23C 16/18***(2006.01)i; ***C07F 15/06***(2006.01)i; ***C23C 16/16***(2006.01)i; ***H10D 64/60***(2025.01)i
FI: C23C16/18; C23C16/16; H01L21/28 301R; C07F15/06

According to International Patent Classification (IPC) or to both national classification and IPC

### B. FIELDS SEARCHED

Minimum documentation searched (classification system followed by classification symbols)

C23C16/18; C07F15/06; C23C16/16; H01L21/28

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII); CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| A | JP 2015-510502 A (SIGMA-ALDRICH CO., LLC) 09 April 2015 (2015-04-09) entire text | 1-33 |
| A | JP 2017-515885 A (SIGMA-ALDRICH CO., LLC) 15 June 2017 (2017-06-15) entire text | 1-33 |
| A | WO 2022/226010 A1 (APPLIED MATERIALS, INC.) 27 October 2022 (2022-10-27) entire text | 1-33 |
| A | JP 2006-057112 A (JSR CORPORATION) 02 March 2006 (2006-03-02) entire text | 1-33 |
| A | JP 2018-172322 A (TOSOH CORP.) 08 November 2018 (2018-11-08) entire text | 1-33 |
| A | JP 2017-007975 A (TOSOH CORP.) 12 January 2017 (2017-01-12) entire text | 1-33 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 November 2024** | **19 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/030046**

**C. DOCUMENTS CONSIDERED TO BE RELEVANT**

| Category* | Citation of document, with indication, where appropriate, of the relevant passages | Relevant to claim No. |
|---|---|---|
| A | US 2018/0102284 A1 (SAMSUNG ELECTRONICS CO., LTD.) 12 April 2018 (2018-04-12) entire text | 1-33 |
| A | JP 2011-246438 A (UBE INDUSTRIES, LTD.) 08 December 2011 (2011-12-08) entire text | 1-33 |
| A | WO 2022/190844 A1 (TANAKA KIKINZOKU KOGYO K.K.) 15 September 2022 (2022-09-15) entire text | 1-33 |
| E, A | JP 2024-120193 A (DAIKIN INDUSTRIES, LTD.) 05 September 2024 (2024-09-05) entire text | 1-33 |

Form PCT/ISA/210 (second sheet) (July 2022)

**INTERNATIONAL SEARCH REPORT**
**Information on patent family members**

International application No.
**PCT/JP2024/030046**

| Patent document cited in search report | Publication date (day/month/year) | Patent family member(s) | Publication date (day/month/year) |
|---|---|---|---|
| JP 2015-510502 A | 09 April 2015 | US 2014/0370192 A1<br>entire text<br>WO 2013/112383 A1<br>EP 2807174 A1<br>TW 201335415 A<br>CN 104136448 A<br>KR 10-2014-0116223 A | |
| JP 2017-515885 A | 15 June 2017 | US 2017/0121356 A1<br>entire text<br>WO 2015/138390 A1<br>EP 3116884 A1<br>TW 201542570 A<br>KR 10-2016-0122273 A<br>CN 106460170 A | |
| WO 2022/226010 A1 | 27 October 2022 | US 2022/0356197 A1<br>US 2023/0382933 A1<br>EP 4326920 A1<br>CN 117178073 A<br>KR 10-2023-0171474 A<br>TW 202309060 A<br>JP 2024-514678 A | |
| JP 2006-057112 A | 02 March 2006 | (Family: none) | |
| JP 2018-172322 A | 08 November 2018 | (Family: none) | |
| JP 2017-007975 A | 12 January 2017 | (Family: none) | |
| US 2018/0102284 A1 | 12 April 2018 | US 2019/0304835 A1<br>KR 10-2018-0038823 A<br>CN 107915760 A | |
| JP 2011-246438 A | 08 December 2011 | (Family: none) | |
| WO 2022/190844 A1 | 15 September 2022 | US 2024/0060176 A1<br>entire text<br>KR 10-2023-0147703 A<br>TW 202248187 A<br>JP 7075518 B1 | |
| JP 2024-120193 A | 05 September 2024 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2021036068 A